# EUROPEAN PATENT APPLICATION

(11) **EP 3 846 072 A1**
(43) Date of publication of application: **07.07.2021**
(21) Application number: 19933212.3
(22) Date of filing: 29.10.2019
(51) Int. Cl.: G06K 9/00

(54) **UNDER-SCREEN FINGERPRINT RECOGNITION APPARATUS AND ELECTRONIC DEVICE**

(71) Applicant: SHENZHEN GOODIX TECHNOLOGY CO., LTD., Shenzhen, Guangdong 518045 (CN)
(72) Inventor: QING, Xiaogang, Shenzhen, Guangdong 518045 (CN); LIU, Wenzheng, Shenzhen, Guangdong 518045 (CN); LI, Shunzhan, Shenzhen, Guangdong 518045 (CN)
(74) Representative: Lam, Alvin
(86) International application number: PCT/CN2019/114058
(87) International publication number: WO 2021/081763

(57) **Abstract**

The present application provides an under-screen fingerprint identification apparatus and an electronic device, where the under-screen fingerprint identification apparatus, applied to an electronic device with a liquid crystal display screen and a middle frame, includes a detection light source and a fingerprint identification module. The detection light source is located below an edge area of a protective cover plate of the liquid crystal display screen, the middle frame is provided with an accommodation space at a position opposite to the detection light source, and the detection light source is at least partially located in the accommodation space and is attached to the middle frame, so as to reduce an increased width of a chin area of the electronic device and contribute to realization of a full screen of the electronic device.

## Description

### TECHNICAL FIELD

The present application relates to the field of display technology, and in particular, to an under-screen fingerprint identification apparatus and an electronic device.

### BACKGROUND

Smartphones have entered an era of full screen, a screen-to-body ratio of a mobile phone is increasing, and under-screen fingerprint identification technology has become a trend. Organic light-emitting diode (OLED for short) can control the on and off of an individual pixel, and the optical under-screen fingerprint identification technology for mobile phones using OLED screens has entered a commercial era.

Different from OLED, a liquid crystal display (LCD) screen generally uses a backlight strip to supplement light for displaying an image on the LCD screen, and cannot control the on and off of an individual area. Due to the existence of a reflective film in a backlight module of the liquid crystal display, visible light emitted by the backlight strip cannot pass through the reflective film to reach a fingerprint identification sensor for fingerprint identification. Therefore, a mobile phone using a LCD screen needs to use an infrared light source to supplement light, thereby realizing an under-screen fingerprint identification function. At present, in the prior art, an infrared light source is arranged in a chin area of an electronic product such as a mobile phone through a flexible circuit board, to supplement infrared light, thereby realizing the under-screen fingerprint identification function. The chin area of a mobile phone is below an edge area of a protective cover plate of a LCD screen, which is often used as an area for LCD wiring.

However, since the infrared light source is arranged in the chin area of the electronic product through a flexible circuit board and a reinforcing plate, the chin area will increase a certain width. Compared with the chin area of the existing electronic product, an increase ratio of the chin area width is relatively high, which obviously decreases a screen-to-body ratio of the mobile phone, hindering realization of a full screen of an electronic product.

### SUMMARY

The present application provides an under-screen fingerprint identification apparatus and an electronic device, which can reduce an increased width of a chin area of an electronic device and contributes to realization of a full screen of the electronic device.

In a first aspect, the present application provides an under-screen fingerprint identification apparatus, which is applied to an electronic device with a liquid crystal display screen and a middle frame, and includes a detection light source and a fingerprint identification module, the detection light source is located below an edge area of a protective cover plate of the liquid crystal display screen, the middle frame is used for supporting the liquid crystal display screen, and the middle frame is provided with an accommodation space at a position opposite to the detection light source, and the detection light source is at least partially located in the accommodation space and is attached to the middle frame; the fingerprint identification module is used for being arranged below the liquid crystal display screen, and a fingerprint identification area thereof is located in a display area of the liquid crystal display screen; where, the detection light source is used for emitting a detection light for fingerprint identification to a finger located above the fingerprint identification area of the liquid crystal display screen, and the fingerprint identification module is used for receiving a fingerprint detection light formed by irradiating the finger with the detection light and returning after passing through the liquid crystal display screen, to obtain fingerprint information of the finger.

In a specific embodiment of the present application, the accommodation space is located on a border of the middle frame.

In a specific embodiment of the present application, the border is an arc-shaped border with a thick middle and thin sides, and the accommodation space is provided close to a middle part of the border.

In a specific embodiment of the present application, the liquid crystal display screen includes a display module with the protective cover plate and a liquid crystal panel, the liquid crystal panel is located below the protective cover plate, and one side of the protective cover plate is provided with an extension part outside of the liquid crystal panel, and the detection light source is located below the extension part and arranged side by side with the liquid crystal panel; where the extension part forms the edge area.

In a specific embodiment of the present application, the border is provided with a support part for supporting the extension part, and the extension part is located on and attached to the support part.

In a specific embodiment of the present application, the accommodation space is located below the support part, and a gap is left between the detection light source and an inner wall of the accommodation space.

In a specific embodiment of the present application, the accommodation space is a groove or a concave structure opened on the border for accommodating the detection light source.

In a specific embodiment of the present application, the detection light source is attached to the border through a first circuit board, and the first circuit board is electrically connected to the detection light source and is for controlling on and off of detection light source.

In a specific embodiment of the present application, the first circuit board is a flexible circuit board.

In a specific embodiment of the present application, the first circuit board is attached to the border through a reinforcing plate, and the reinforcing plate is used for supporting the detection light source, where the first circuit board is located between the reinforcing plate and the detection light source.

In a specific embodiment of the present application, a wavelength of the detection light is different from that of a backlight provided by a backlight module of the liquid crystal display screen and used for displaying an image, where the backlight module is located below the display module of the liquid crystal display screen.

In a specific embodiment of the present application, the detection light emitted by the detection light source is infrared light, and the backlight provided by the backlight module is visible light.

In a specific embodiment of the present application, a light-emitting area of the detection light source is located at a side of the detection light source close to the fingerprint identification area, so that the detection light in the light-emitting area can emit out of the middle frame for increasing an intensity of the detection light irradiated on the finger.

In a specific embodiment of the present application, the detection light source includes a light-emitting element for emitting the detection light, and the light-emitting element is located at the side of the detection light source close to the fingerprint identification area; and/or
the light-emitting element is obliquely arranged in the detection light source, so that the detection light in the light-emitting area can emit out of the middle frame for increasing the intensity of the detection light irradiated on the finger above the fingerprint identification area.

In a specific embodiment of the present application, the middle frame and a second circuit board of the LCD screen are provided with a reflective layer at a position opposite to a light-emitting area of the detection light source, where the second circuit board is connected to a liquid crystal panel of the liquid crystal display screen, and the reflective layer is used for causing the detection light in the light-emitting area to emit out of the protective cover plate, so as to increase an intensity of the detection light irradiated on the finger above the fingerprint identification area.

In a specific embodiment of the present application, the reflective layer is respectively arranged in the accommodation space at a position opposite to the light-emitting area and on a side of the second circuit board facing the detection light source.

In a specific embodiment of the present application, the second circuit board is arranged on a same side of the liquid crystal panel and a backlight module, and is arranged close to the detection light source.

In a specific embodiment of the present application, the reflective layer is a reflective film for reflecting the detection light, or the reflective layer is a coating formed by spraying using a reflective material and used for reflecting the detection light.

In a specific embodiment of the present application, the fingerprint identification module is arranged close to the detection light source, where the detection light source is located below the protective cover plate of a non-display area of the liquid crystal display screen, and the fingerprint identification module is located below a backlight module of a display area of the liquid crystal display screen.

In a specific embodiment of the present application, the middle frame further includes a support plate located in a middle part of the border, the border is arranged on a peripheral side of the support plate, and a first accommodation cavity and a second accommodation cavity vertically provided are formed between the border and the support plate, where part of the liquid crystal display screen is located in the first accommodation cavity, and a main board of the electronic device is located in the second accommodation cavity.

In a specific embodiment of the present application, the fingerprint identification module is located below the liquid crystal display screen, where the support plate is provided with a first opening; the fingerprint identification module is arranged opposite to the first opening and is attached to the support plate or a bottom of the backlight module of the liquid crystal display screen, and the first opening is used for transmitting the fingerprint detection light passing through the liquid crystal display screen to the fingerprint identification module.

In a specific embodiment of the present application, the liquid crystal display screen is provided with a light-transmitting area for transmitting the fingerprint detection light to the fingerprint identification module through a backlight module.

In a specific embodiment of the present application, the liquid crystal display screen includes the backlight module, the backlight module includes an optical module capable of transmitting the fingerprint detection light and a steel plate, the fingerprint identification module is located below the steel plate, and the steel plate is provided with a second opening at a position opposite to the fingerprint identification module, where the second opening is used for transmitting the fingerprint detection light transmitted through the optical module to the fingerprint identification module, and the second opening is the light-transmitting area.

In a second aspect, the present application provides an electronic device, which includes a middle frame, a liquid crystal display screen provided in the middle frame, and the under-screen fingerprint identification apparatus as described in any one of the above.

The present application provides an under-screen fingerprint identification apparatus and an electronic device, where a detection light source is located below an edge area of a protective cover plate of a liquid crystal display screen, and the middle frame is provided with an accommodation space at a position opposite to the detection light source, so that at least part of the detection light source is located in the accommodation space and is attached to the middle frame, thereby reducing an increased width of a chin area of an electric device while realizing the under-screen fingerprint identification function, which contributes to realization of a full screen of an electronic device, solving the problem that an infrared light source in an existing electronic product is arranged in a chin area of an electronic product through a circuit board, which causes an increase ratio of the chin area width of the electronic product to be relatively high and hinders realization of a full screen of the electronic product.

### BRIEF DESCRIPTION OF DRAWINGS

In order to describe the technical solutions of the embodiments in the present application or in the prior art more clearly, the drawings required in descriptions of the embodiments or the prior art are briefly introduced below. Obviously, the drawings in the following descriptions are some embodiments of the present application, and for those of ordinary skill in the art, other drawings may be obtained according to these drawings without creative efforts.
FIG. 1 is a schematic structural diagram of an existing liquid crystal display screen;
FIG. 2 is a schematic structural diagram of an infrared light source being arranged in a chin area of a mobile phone in existence;
FIG. 3 is a schematic structural diagram of an infrared light source being arranged in a chin area of a mobile phone from another angle in existence;
FIG. 4 is a schematic structural diagram of a widened chin area of a mobile phone in the prior art;
FIG. 5 is a schematic structural diagram of a mobile phone equipped with an under-screen fingerprint identification apparatus according to Embodiment 1 of the present application;
FIG. 6 is a schematic assembly diagram of a detection light source and a middle frame according to Embodiment 2 of the present application;
FIG. 7 is another schematic assembly diagram of a detection light source and a middle frame according to Embodiment 2 of the present application;
FIG. 8 is a schematic structural diagram of a mobile phone equipped with an under-screen fingerprint identification apparatus according to Embodiment 3 of the present application.

### Descriptions of reference numerals:

mobile phone-100; middle frame-10; border-11; accommodation space-111; support part-112; support plate-12; first opening-121; liquid crystal display screen-20; display module-21; protective cover plate-211; extension part-2111; display area-212; non-display area-213; fingerprint identification area-214; liquid crystal panel-212; second circuit board-2121; backlight module-22; optical module-221; steel plate-222; second opening-2221; backlight source-223; under-screen fingerprint identification apparatus-30; detection light source-31; first circuit board-311; light-emitting element-312; fingerprint identification module-32; reflective layer-40; main board-50; bonding layer-60.

### DESCRIPTION OF EMBODIMENTS

In order to make objectives, technical solutions, and advantages of the embodiments of the present application clearer, the technical solutions of the embodiments of the present application will be described clearly and completely in conjunction with the drawings of the embodiments of the present application. Obviously, embodiments that are described are part of the embodiments of the present application, not all of the embodiments. Based on the embodiments of the present application, all other embodiments obtained by those of ordinary skill in the art without creative efforts belong to the protection scope of the present application.

The following is a detailed description of the technical solutions of the present application with specific embodiments. The following specific embodiments may be combined with each other, and same or similar concepts or processes may not be repeated in some embodiments.

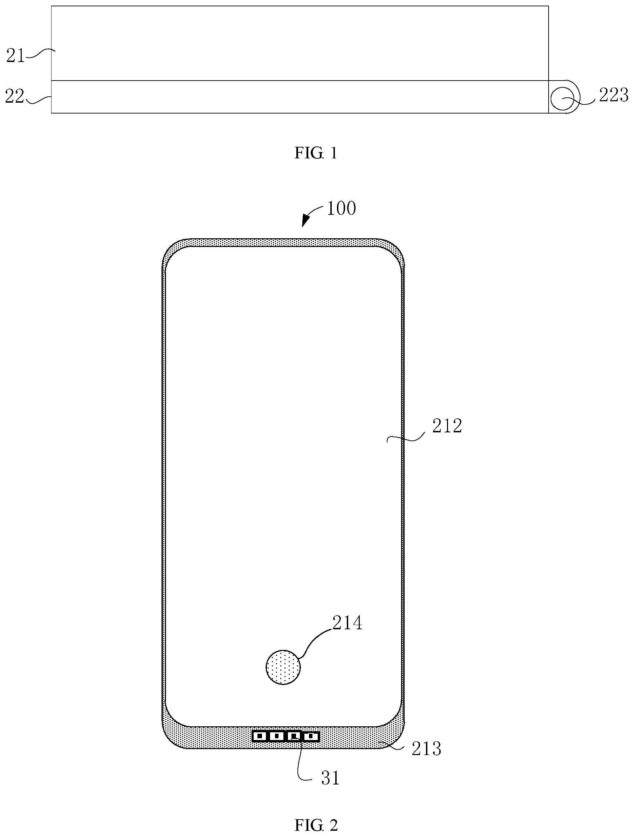

Smartphones have entered an era of full screen, a screen-to-body ratio of a mobile phone is increasing, and under-screen fingerprint identification technology has become a trend. At present, referring to FIG. 1 and FIG. 2, a liquid crystal display (LCD) screen described in BACKGROUND generally uses a backlight strip (i.e., a backlight source 223) to supplement light for displaying an image on the LCD screen, and cannot control the on and off of an individual area (such as a fingerprint identification area 214). Due to the existence of a reflective film in a backlight module of the liquid crystal display, visible light emitted by the backlight strip cannot pass through the reflective film to reach a fingerprint identification sensor for fingerprint identification. At present, a mobile phone using a LCD screen needs to use an infrared light source to supplement light, thereby realizing an under-screen fingerprint identification function. In the prior art, as shown in FIG. 2 to FIG. 4, an infrared light source is arranged in a chin area of an electronic product such as a mobile phone through a flexible circuit board, to supplement infrared light, thereby realizing the under-screen fingerprint identification function. The chin area of an electronic product is below an edge area of a protective cover plate of a LCD screen, which is often used as an area for LCD wiring.

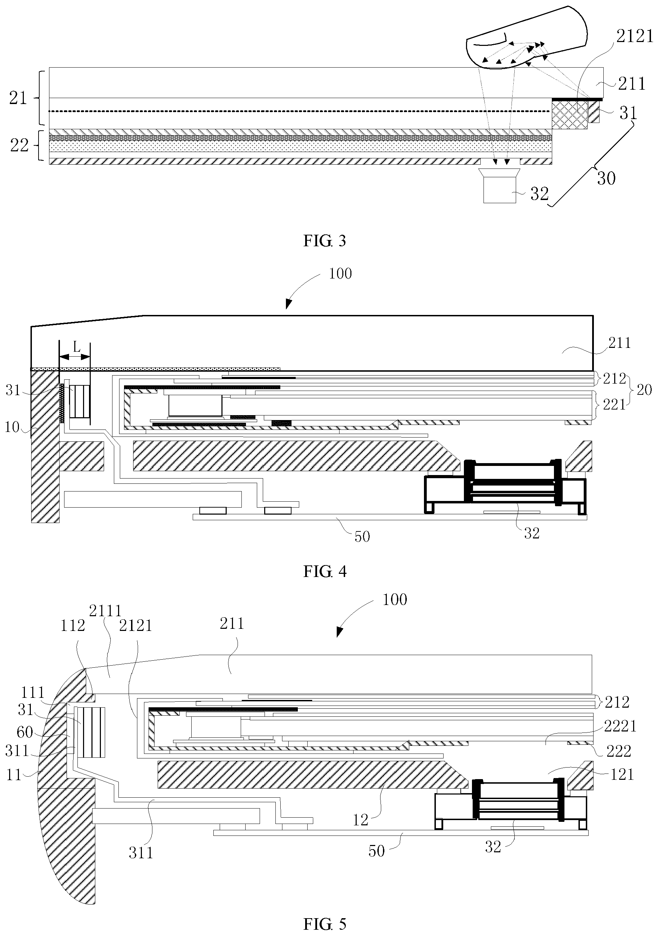

However, referring to FIG. 4, since the infrared light source is arranged in the chin area of the electronic product through a flexible circuit board (i.e., a first circuit board 311) and a reinforcing plate and is attached to the middle frame of the electronic device, a length of the increased width of the chin area is L, where L is greater than or equal to 0.7 mm. Compared with a 4 mm chin area of an existing electronic product using a LCD screen, an increase radio of the width equal to or greater than 0.7mm is relatively high, which obviously decreases a screen-to-body ratio of an electronic device such as a mobile phone, affects a front appearance of the mobile phone, and is contrary to a development trend of full screen of the existing electronic device, and hinders realization of a full screen of an electronic product.

Therefore, the present application provides an under-screen fingerprint identification apparatus and an electronic device, which can reduce an increased width of a chin area of an electronic device and contribute to realization of a full screen of the electronic device.

Embodiments of the present application provide an under-screen fingerprint identification apparatus and an electronic device, where the electronic device may include but is not limited to electronic products or components such as a mobile phone, a tablet computer, a television, a laptop, a digital photo frame, a navigator, a fingerprint lock, and the like which adopt a liquid crystal display screen. The electronic device includes a middle frame, a liquid crystal display screen arranged in the middle frame, and an under-screen fingerprint identification apparatus according to embodiments of the present application.

The following embodiments of the present application take an application scenario of a mobile phone with a liquid crystal display screen as an example to further describe the under-screen fingerprint identification apparatus of the present application.

### Embodiment 1

FIG. 5 is a schematic structural diagram of a mobile phone equipped with an under-screen fingerprint identification apparatus according to Embodiment 1 of the present application.

Referring to FIG. 5, an embodiment of the present application provides an under-screen fingerprint identification apparatus, which is applied to an electronic device with a liquid crystal display screen 20 and a middle frame 10, and includes a detection light source 31 and a fingerprint identification module 32, the detection light source 31 is located below an edge area of a protective cover plate 211 of the liquid crystal display screen 20, the middle frame 10 is used for supporting the liquid crystal display screen 20, and the middle frame 10 is provided with an accommodation space 111 at a position opposite to the detection light source 31, and the detection light source 31 is at least partially located in the accommodation space 111 and is attached to the middle frame 10; the fingerprint identification module 32 is used for being arranged below the liquid crystal display screen 20, and a fingerprint identification area 214 thereof is located in a display area 212 of the liquid crystal display screen 20. Where, the detection light source 31 is used for emitting a detection light for fingerprint identification to a finger located above the fingerprint identification area 214 of the liquid crystal display screen 20, and the fingerprint identification module 32 is used for receiving a fingerprint detection light formed by irradiating the finger with the detection light and returning after passing through the liquid crystal display screen 20, to obtain fingerprint information of the finger.

It should be noted that in the embodiment, as shown in FIG. 5, a mobile phone 100 may include the liquid crystal display screen 20 and a back cover (not marked in the figure), and the middle frame 10 is installed between the liquid crystal display screen 20 and the back cover, for supporting the liquid crystal display screen 20. Specifically, other internal components of the mobile phone 100, such as a main board 50 and a battery (not marked in the figure) of the mobile phone 100, may be arranged on the middle frame 10. Specifically, the middle frame 10 may be connected to the liquid crystal display screen 20 and the back cover by clamping, bonding, or by a fastener. In the embodiment, the middle frame 10 may refer to a structure of a middle frame 10 in an existing mobile phone 100. In the embodiment, a structure of the middle frame 10 will not be further described.

Where, referring to FIG. 5, the edge area of the protective cover plate 211 may correspond to a chin area of an electronic device such as the mobile phone 100, which may be used as a wiring area of a liquid crystal panel 212, and the detection light source 31 may be arranged below an edge extension part 2111 of the protective cover plate 211 and arranged side by side with a main body area of the liquid crystal panel 212 (i.e., does not overlap with each other), and emit a detection light for fingerprint identification to the finger located above the fingerprint identification area 214 of the liquid crystal display screen 20.

Specifically, as described in BACKGROUND, when the detection light source 31 is arranged in the chin area of the mobile phone 100 and is attached to the middle frame 10 through a flexible circuit board and a reinforcing plate to supplement light, so as to realize the under-screen fingerprint identification function, a width of the chin area may be increased, which may affect a screen-to-body ratio of the mobile phone 100 and the front appearance of the mobile phone 100, resulting in a decrease in the screen-to-body ratio of the mobile phone 100, which is contrary to the development trend of full screen of the existing electronic device and hinders realization of a full screen of the mobile phone 100.

In view of a certain thickness of the middle frame 10 of the mobile phone 100, for example, when the middle frame 10 of the mobile phone 100 adopts an arc-shaped border with a thick middle and thin sides, the thickness of the part of the arc-shaped border close to the protective cover plate 211 is about 0.65 mm. The closer to the middle part, the greater the thickness of the arc-shaped border, and a maximum thickness (i.e., width) of the middle part is about 1.3 mm. Therefore, in the embodiment, referring to FIG. 5, the detection light source 31 is arranged below the edge area of the protective cover plate 211, and the middle frame 10 is provided with the accommodation space 111 at a position opposite to the detection light source 31, so that part of the structure of the detection light source 31 is located in the accommodation space 111. Therefore, while realizing emitting the detection light (i.e., supplementing light) to the finger above the fingerprint identification area 214, compared with the manner in the prior art that an infrared light source is directly arranged in the chin area of the mobile phone 100 for supplementing light (as shown in FIG. 2 to FIG. 4), the embodiment of the present application can reduce the increased width of the chin area, avoid obvious reduction of the screen-to-body ratio of the mobile phone 100, and contribute to the realization of a full screen of the mobile phone 100.

Or, while satisfying that the detection light emitted by the detection light source 31 can irradiate the finger above the fingerprint identification area 214, a whole structure of the detection light source 31 may be located in the accommodation space 111, that is, the whole structure of the detection light source 31 is buried in the middle frame 10. At this time, while realizing emitting the detection light (i.e., supplementing light) to the finger above the fingerprint identification area 214, compared with the manner in the prior art that an infrared light source is directly arranged in the chin area of the mobile phone 100 for supplementing light, the width of the chin area of the mobile phone 100 may not be increased, i.e., the width of the chin area of the mobile phone 100 may remain unchanged, which contributes to the realization of a full screen of the mobile phone 100.

It should be noted that when part of the structure of the detection light source 31 is located in the accommodation space 111, an increased width of the chin area of the mobile phone 100 depends on a width of the detection light source 31 outside of the accommodation space 111. Therefore, in a practical application, without affecting the strength of the middle frame 10 and the light supplementing effect on the finger above the fingerprint identification area 214, a depth of the accommodation space 111 may be increased, so that more parts of the detection light source 31 are located in the accommodation space 111, to reduce or not increase the width of the chin area.

In order not to increase the width of the chin area, in the embodiment, when part of the structure of the detection light source 31 is located in the accommodation space 111, the part of the detection light source 31 outside of the accommodation space 11 may be located in a safe space (about 0.8 mm in width) between a bent part of a second circuit board 2121 of the liquid crystal panel 212 and the middle frame, so as to achieve the purpose of not increasing the width of the chin area. Specifically, when part of the structure of the detection light source 31 is located in the accommodation space 111, the part of the detection light source 31 outside of the accommodation space 11 may be a light emitting surface or a part of an external light emitting surface of the detection light source. Taking the detection light source 31 being an infrared lamp with a light emitting surface with a thickness (i.e., width) of 0.3 mm as an example, when a width of the infrared lamp outside of the accommodation space 111 is 0.2 mm, the safe space (about 0.8 mm in width) between the bent part of the second circuit board 2121 of the liquid crystal panel 212 and the middle frame 10 may be used to achieve the purpose of not increasing the width of the chin area.

Or, as an achievable manner, a detection light source 31 with a small thickness (i.e. thin) of the light emitting surface in the prior art may be selected to reduce or not increase the width of the chin area. In the embodiment, the depth of the accommodation space 111 is not further limited.

Where, in the embodiment, the accommodation space 111 is adapted to the structure of the detection light source 31, which may be a groove opened on the middle frame 10, or the accommodation space 111 may be a concave structure on the middle frame 10. In the embodiment, the structure of the accommodation space 111 is not further limited. It should be noted that the screen-to-body ratio is a ratio of a screen area to an entire machine area, that is, the larger the screen, the larger the screen-to-body ratio, which is more beneficial to the user experience. Full screen is a relatively broad definition for a design of the mobile phone 100 with an ultra-high screen-to-body ratio in the industry of the mobile phone 100. A full screen mobile phone 100 can improve the appearance of the mobile phone 100 and make the mobile phone 100 look more technical. In addition, the front area of the phone body can accommodate a larger screen, which significantly improves the visual experience

In the embodiment, the detection light source 31 is located below the edge area of the protective cover plate 211 of the liquid crystal display screen 20, and the middle frame 10 is provided with an accommodation space 111 at a position opposite to the detection light source 31, so that at least part of the detection light source 31 is located in the accommodation space 111 and is attached to the middle frame 10, thereby reducing the increased width of the chin area of the mobile phone 100 while realizing the under-screen fingerprint identification function, which contributes to realization of a full screen of the electronic device, solving the problem that an infrared light source in an existing electronic product is arranged in the chin area of the electronic product through a circuit board, which causes an increase radio of the chin area width of the electronic product to be relatively high and hinders realization of a full screen of the electronic product.

Specifically, referring to FIG. 5, the fingerprint identification area 214 is located in the display area 212 of the liquid crystal display screen 20. Where, the display area 212 of the liquid crystal display screen 20 is an area for displaying an image on the liquid crystal display screen 20 or the mobile phone 100. The fingerprint identification area 214 may specifically be an area for a user to press a finger to implement a fingerprint input operation.

To prevent the arrangement of the detection light source 31 from affecting a display effect of the display area 212 of the liquid crystal display screen 20, referring to FIG. 5, the detection light source 31 is located below a non-display area 213 of the liquid crystal display screen 20, where the non-display area 213 is located at a periphery of the display area 212. The fingerprint identification module 32 is located below a light-transmitting area of the liquid crystal display screen 20, so that a fingerprint detection light carrying fingerprint information can be transmitted to the fingerprint identification module 32 through the light-transmitting area.

It should be understood that the non-display area 213 of the liquid crystal display screen 20 is an area of the liquid crystal display screen 20 that does not display or has no display function.

Further, the accommodation space 111 is located on a border 11 of the middle frame 10, so that the detection light source 31 is located below the edge area of the protective cover plate 211, and emits, in the chin area of the mobile phone 100, a detection light to the finger located above the fingerprint identification area 214.

Specifically, in the embodiment, referring to FIG. 5, in order to make the appearance of the mobile phone 100 more rounded and beautiful, the border 11 may be an arc-shaped border with a thick middle and thin sides. Since the part of the border 11 close to the protective cover plate 211 has a small thickness, and cannot open the accommodation space 111, the accommodation space 111 is provided close to the middle part of the border 11, so that the accommodation space 111 can be opened on the border 11, and at least part of the detection light source 31 is located in the accommodation space 111, which can reduce the increased width of the chin area compared with the manner in the prior art that the infrared light source is directly arranged in the chin area of the mobile phone 100 to supplement light. It should be noted that, when the border 11 is a strip-shaped border 11 with a uniform thickness, the accommodation space 111 may be located at the end of the border 11 close to the protective cover plate 211 (that is, an end part of the border 11).

In the following, the embodiment of the present application takes the aforementioned arc-shaped border as an example to further describe the under-screen fingerprint identification apparatus of the present application.

Referring to FIG. 5, the liquid crystal display screen 20 includes a display module 21 with the protective cover plate 211 and the liquid crystal panel 212. The liquid crystal panel 212 is located below the protective cover plate 211, and one side of the protective cover plate 211 is provided with an extension part 2111 outside of the liquid crystal panel 212. The detection light source 31 is located below the extension part 2111 and arranged side by side with the liquid crystal panel 212, so that the detection light emitted by the detection light source 31 can better penetrate through the liquid crystal display screen 20 to reduce loss of the detection light in optical path transmission, and improve the light utilization rate; where, the extension part 2111 forms the edge area.

In order to better support the liquid crystal display screen 20, as shown in FIG. 5, the border 11 is provided with a support part 112 for supporting the extension part 2111, and the extension part 2111 is located on and attached to the support part 112, thereby realizing supporting the liquid crystal display screen 20. Where, in the embodiment, the way of attaching the extension part 2111 and the support part 112 includes but is not limited to bonding.

Specifically, the support part 112 and the border 11 may an integrally formed structure, or the support part 112 and the border 11 may be a split structure. In order to make the middle frame 10 have a better strength, the support part 112 and the frame 11 in the embodiment are in an integrally formed structure.

It should be noted that, there is a certain distance between the detection light source 31 and the liquid crystal panel 212, and an area formed by the distance may be used for wiring of the liquid crystal panel 212 and bending of the second circuit board 2121 of the liquid crystal panel 212.

Furthermore, as shown in FIG. 5, the accommodation space 111 is located below the support part 112, so that the detection light source 31 is located below the extending part 2111, and a gap is left between the detection light source 31 and the inner wall of the accommodation space 111, to reduce the possibility that the detection light emitted by the detection light source 31 is blocked by the middle frame 10, at the same time, it can facilitate installation and disassembly of the detection light source 31.

For example, the accommodation space 111 may be a groove or a concave structure opened on the frame 11 for accommodating the detection light source 31, and a structural size of the groove or the concave structure is required to be larger than that of the detection light source 31, so as to facilitate the installation and disassembly of the detection light source 31.

In order to realize controlling the detection light source 31, as shown in FIG. 5, the detection light source 31 is attached to the border 11 through a first circuit board 311, the first circuit board 311 is electrically connected to the detection light source 31 for controlling the on or off of the detection light source 31, where a part of the first circuit board 311 for fixing the detection light source 31 is located in the accommodation space 111. In the embodiment, the way of attaching the first circuit board 311 and the border 11 includes but is not limited to bonding. For example, the first circuit board 311 may be attached to the border 11 through a bonding layer 60.

Specifically, in order to facilitate connection between the first circuit board 311 and a main board 50 of an electronic device such as a mobile phone 100 or other circuit boards, the first circuit board 311 may be a flexible circuit board, which is convenient for bending the first circuit board 311 to realize connection between the first circuit board 311 and the main board 50 of the mobile phone 100. For example, the first circuit board 311 may be directly connected to the main board 50 of the mobile phone 100 through the middle frame 10, or the first circuit board 311 may be connected to the main board 50 of the mobile phone 100 through a second circuit board 2121, and power is supplied to the detection light source 31 through the main board 50, thereby realizing the function of the detection light source 31. Where, a connecting manner between the first circuit board 311 and the main board 50 or the second circuit board 2121 includes but is not limited to welding. Where, the second circuit board 2121 is a circuit board connected to the liquid crystal panel of the liquid crystal display screen. In the embodiment, the connecting manner between the first circuit board 311 and the main board 50 of the mobile phone 100 is not further limited.

Furthermore, in order to enhance the bonding strength between the detection light source 31 and the middle frame 10, the first circuit board 311 may further be attached to the border 11 through a reinforcing plate (not shown in the figure), and the reinforcing plate is used for supporting the detection light source 31. Where, the first circuit board 311 may be located between the reinforcing plate and the detection light source 31, and is attached to the border 11 through the reinforcing plate, to enhance the bonding strength between the detection light source 31 and the middle frame 10. Where, the way of attaching the reinforcing plate and the border 11 includes but is not limited to bonding.

In the embodiment, in order to avoid interference of the detection light emitted by the detection light source 31 on a display effect of the liquid crystal display screen 20, a wavelength of the detection light is different from that of the backlight provided by the backlight module 22 of the liquid crystal display screen 20, that is, a wavelength band of the detection light or the fingerprint detection light is different from that of the backlight. Where, the backlight module 22 is located below the display module 21 of the liquid crystal display screen 20. Therefore, the detection light emitted by the detection light source 31 of the embodiment of the present application can not only realize under-screen fingerprint identification, but also reduce the interference of the detection light on the display effect of the liquid crystal display screen 20, so as to avoid affecting the display effect of an image.

Further, in the embodiment, the detection light emitted by the detection light source 31 may be infrared light or other optical signals with a wavelength outside the visible light band and capable of realizing fingerprint identification, that is, in the embodiment, the detection light includes but is not limited to infrared light. The backlight provided by the backlight module 22 is visible light, so that a user cannot see or perceive the detection light for fingerprint identification through the liquid crystal display screen 20. Since the penetration ability of the infrared light is stronger than that of the visible light, a signal of the fingerprint detection light penetrating through the liquid crystal display screen 20 and the backlight module 22 may be enhanced more effectively, thereby improving the fingerprint identification effect. Therefore, in the embodiment, the detection light is preferably infrared light, such as infrared light with a wavelength of 940 nm.

Furthermore, as shown in FIG. 5, the fingerprint identification module 32 is arranged close to the detection light source 31, where the detection light source 31 is located below the protective cover plate 211 of the non-display area 213 of the liquid crystal display screen 20, and the fingerprint identification module 32 is located below the backlight module 22 of the display area 212 of the liquid crystal display screen 20.

In the embodiment, the fingerprint identification module 32 may refer to a structure of the fingerprint identification module 32 in the prior art. In the prior art, the structure of the fingerprint identification module 32 will not be further described.

Further, in the embodiment, as shown in FIG. 5, the middle frame 10 further includes a support plate 12 located in the middle part of the border 11, the border 11 is arranged on a peripheral side of the support plate 12, and a first accommodation cavity and a second accommodation cavity vertically arranged are formed between the border 11 and the support plate 12. Part of the liquid crystal display screen 20 is located in the first accommodation cavity, the main board 50 of the electronic device is located in the second accommodation cavity, and the liquid crystal display screen 20 is isolated from the main board 50 of the electronic device such as the mobile phone 100 through the support plate 12. In the embodiment, the middle frame 10 composed of the support plate 12 and the border 11 may be an integrally formed structure or a split structure. Where, when the support plate 12 and the border 11 are in a split structure, the connecting manner of the support plate 12 and the border 11 includes but is not limited to bonding or clamping.

Specifically, as shown in FIG. 5, in the embodiment, the fingerprint identification module 32 may be located below the liquid crystal display screen 20, where the support plate 12 is provided with a first opening 121, the fingerprint identification module 32 is arranged opposite to the first opening 121 and is attached to the support plate 12, and the first opening 121 is used for transmitting the fingerprint detection light passing through the liquid crystal display screen 20 to the fingerprint identification module 32.

Specifically, as shown in FIG. 5, the fingerprint identification module 32 may be integrally attached to a lower surface of the support plate 12 of the middle frame 10 and located below the first opening 121, or at least part of the fingerprint identification module 32 may be located at the first opening 121. In the embodiment, the arrangement manner for the fingerprint identification module 32 is not further limited, as long as it satisfies that the fingerprint detection light can enter the fingerprint identification module 32 through the first opening 121.

Where, the opening shape and size of the first opening 121 may satisfy that the fingerprint detection light can basically pass through, so as to avoid affecting fingerprint image acquisition due to the fingerprint detection light cannot normally pass through the middle frame 10. In the embodiment, the size of the first opening 121 is based on a receiving optical path of the fingerprint identification module 32.

Or, as an alternative manner, the fingerprint identification module 32 may be attached to a bottom of the backlight module 22 of the liquid crystal display screen 20, and the fingerprint identification module 32 is arranged on the support plate 12 through the first opening 121. Where, the way of attaching the fingerprint identification module 32 and the backlight module 22 includes but is not limited to bonding.

In order to enable the fingerprint detection light carrying fingerprint information to pass through the liquid crystal display screen 20, the liquid crystal display screen 20 is provided with a light-transmitting area for transmitting the fingerprint detection light to the fingerprint identification module 32 through the backlight module 22.

It should be noted that, in a practical application, the relative position of the detection light source 31, the light-transmitting area and the fingerprint identification module 32 may be adjusted as needed, but the adjusted relative position of the detection light source 31, the light-transmitting area and the fingerprint identification module 32 should satisfy that the detection light emitted by the detection light source 31 can irradiate the finger above the fingerprint identification area 214, and the fingerprint detection light formed by the reflection or transmission of the finger can enter the fingerprint identification module 32 through the light-transmitting area of the backlight module 22.

Further, the liquid crystal display screen 20 includes the backlight module 22, the backlight module 22 includes an optical module 221 capable of transmitting the fingerprint detection light and a steel plate 222. The fingerprint identification module32 is located below the steel plate, and the steel plate 222 is provided with a second opening 2221 at a position opposite to the fingerprint identification module 32, the second opening 2221 is used for transmitting the fingerprint detection light passing through the optical module 221 to the fingerprint identification module 32, where the second opening is the light-transmitting area.

Where, the opening shape and size of the second opening 2221 may satisfy that the fingerprint detection light can basically pass through, so as to avoid affecting fingerprint image acquisition due to the fingerprint detection light cannot normally pass through the backlight module 10 of the liquid crystal display screen 20. In the embodiment, the size of the second opening 2221 is based on the receiving optical path of the fingerprint identification module 32.

Specifically, the backlight module 22 is arranged below the liquid crystal panel 212 for providing a backlight source for the liquid crystal panel 212; the backlight module 22 includes a backlight source 223, and the visible light emitted by the backlight source is converted into a uniform surface light source through the optical module 221 and irradiates the liquid crystal panel 212 to make the liquid crystal panel to display an image. It should be noted that, in the embodiment, the optical module 221 may include a reflective film, a light guide plate, a brightness enhancement film, etc., and the optical module 221 may refer to the optical module 221 in the prior art, which at least partially allows the fingerprint detection light to pass through. In the embodiment, it will not be further described.

In the under-screen fingerprint identification apparatus provided by the present application, the detection light source is located below the edge area of the protective cover plate of the liquid crystal display screen, and the middle frame is provided with an accommodation space at a position opposite to the detection light source, so that at least part of the detection light source is located in the accommodation space and is attached to the middle frame, thereby reducing an increased width of the chin area of the mobile phone while realizing the under-screen fingerprint identification function, which contributes to realization of a full screen of the electronic device.

### Embodiment 2

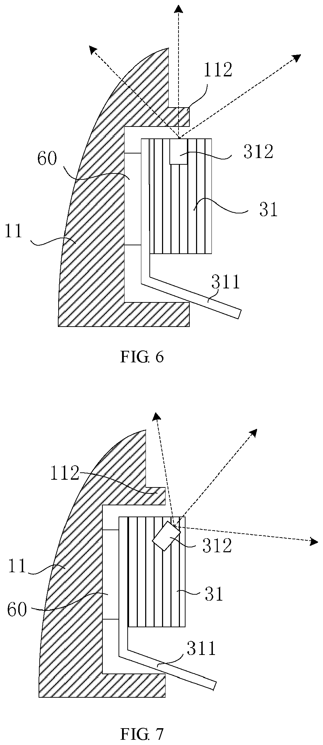

FIG. 6 is a schematic assembly diagram of a detection light source and a middle frame according to Embodiment 2 of the present application, and FIG. 7 is another schematic assembly diagram of a detection light source and a middle frame according to Embodiment 2 of the present application.

On the basis of Embodiment 1 mentioned above, as shown in FIG. 6 and FIG. 7, since at least part of the detection light source 31 is buried in the middle frame 10, in order to avoid the detection light in a light-emitting area of the detection light source 31 being blocked by the middle frame 10, the light-emitting area of the detection light source 31 is located on a side of the detection light source 31 close to a fingerprint identification area 214, so that the detection light in the light-emitting area can emit out of the middle frame 10 for increasing the intensity of the detection light irradiated on the finger.

Furthermore, as shown in FIG. 7, the detection light source 31 includes a light-emitting element 312 for emitting the detection light. In order to make the light-emitting area of the detection light source 31 be located on the side of the detection light source 31 close to the fingerprint identification area 214, the light-emitting element 312 may be located on the side of the detection light source 31 close to the fingerprint identification area 214, and/or, the light-emitting element 312 may be obliquely arranged in the detection light source 31, so that the detection light in the light-emitting area can emit out of the middle frame 10 for increasing the intensity of the detection light irradiated on the finger above the fingerprint identification area 214.

Specifically, in the embodiment, the light-emitting element 312 may be located at the side of the detection light source 31 close to the fingerprint identification area 214, or the light-emitting element 312 may be obliquely arranged in the detection light source 31, or the light-emitting element 312 may be located at the side of the detection light source 31 close to the fingerprint identification area 214 and obliquely arranged in the detection light source 31, so that the detection light in the light-emitting area of the detection light source 31 can emit out of the middle frame 10 for increasing the intensity of the detection light irradiated on the finger above the fingerprint identification area 214. In the embodiment, the arrangement manner of the light-emitting element 312 in a detection light source 31 assembly is not further limited.

It should be understood that, as shown in FIG. 7, the inclination angle of the light-emitting element 312 in the detection light source 31 is related to the arrangement manner of the detection light source 31 in the accommodation space 111 (i.e., a partial structure of the detection light source 31 is located in the accommodation space 111 or a whole structure of the detection light source 31 is located in the accommodation space 111) and the light-emitting area of the detection light source 31 (i.e., an irradiation angle of the detection light source 31). Therefore, in the embodiment, the inclination angle of the light-emitting element 312 may be adjusted according to the arrangement manner of the detection light source 31 in the accommodation space 111 and the light-emitting area of the detection light source 31, as long as it is satisfied that the light-emitting element 312 can be arranged in the detection light source 31 obliquely, so that the detection light in the light-emitting area can emit out of the middle frame 10 for increasing the intensity of the detection light irradiated on the finger above the fingerprint identification area 214. In the embodiment, the inclination angle of the light-emitting element 312 in the detection light source 31 is not further limited.

It should be noted that, in order to make the light-emitting area of the detection light source 31 be located at the side of the detection light source 31 close to the fingerprint identification area 214, as an alternative manner, in the embodiment, an optical element (not shown in the figure) may be provided in the detection light source 31 to change the light emitting angle of the detection light source 31, so that the detection light in the light-emitting area can emit out of the middle frame 10 to increase the intensity of the detection light irradiated on the finger. Where, in the embodiment, the optical element includes but is not limited to a lens.

Specifically, the detection light source 31 may be an infrared light source, and the detection light emitted by the detection light source 31 is infrared light, thus the fingerprint detection light formed by irradiating the finger with the detection light and reflecting or transmitting on the finger is also infrared light. For example, the detection light source 31 may be an infrared light source such as an infrared lamp, an infrared vertical cavity surface emitting laser (VCSEL for short), an infrared laser diode, etc. In the embodiment, the type of the detection light source 31 is not further limited. It should be noted that, in the embodiment, the light-emitting element 312 is packaged to form the detection light source 31. Accordingly, the light-emitting element 312 is an element capable of emitting light in the detection light source 31 (such as a light-emitting chip), and the light-emitting element 312 may refer to an existing element capable of emitting light in the detection light source 31. In the embodiment, the light-emitting element 312 will not be further described.

In the under-screen fingerprint identification apparatus provided by the present application, the detection light source is located below the edge area of the protective cover plate of the liquid crystal display screen, so that at least part of the detection light source is located in the accommodation space and is attached to the middle frame. At the same time, the light-emitting area of the detection light source is located at the side of the detection light source close to the fingerprint identification area, so that the detection light can emit out of the middle frame. Therefore, the under-screen fingerprint identification effect can be improved while the increased width of the chin area of the electronic device is reduced, which contributes to realization of a full screen of the electronic device.

### Embodiment 3

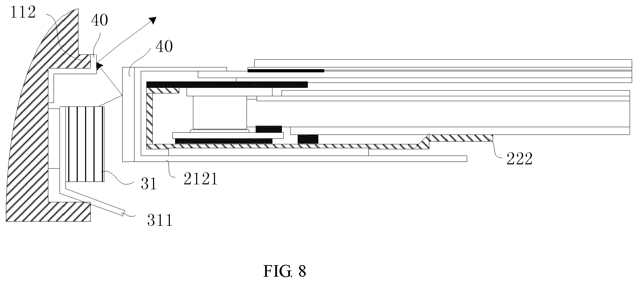

FIG. 8 is a schematic structural diagram of a mobile phone equipped with an under-screen fingerprint identification apparatus according to Embodiment 3 of the present application.

On the basis of Embodiment 1 and Embodiment 2 above, when the border 11 of the middle frame 10 adopts an arc-shaped border, as described in the above embodiment, the thickness of the part of the arc-shaped border close to the protective cover plate 211 is only 0.6 mm, and it is impossible to open an accommodation space111. The thickness of the middle part of the border is about 1.3 mm, therefore, the opening of the accommodation space 111 should be close to the middle part of the border 11. Since the accommodation space 111 is close to the middle part of the border 11 of the middle frame 10, compared with the prior art in which a detection light source 31 is directly arranged in a chin area of a mobile phone 100 (as shown in FIG. 3), the detection light source 31 is far from the protective cover plate 211 of the liquid crystal display screen 20, and part of the light-emitting area of the detection light source 31 may be blocked, resulting in low light utilization rate of the detection light source 31.

Therefore, as shown in FIG. 8, in the embodiment, the middle frame 10 and a second circuit board 2121 of the liquid crystal display screen 20 are provided with a reflective layer 40 at a position opposite to the light-emitting area of the detection light source 31, and detection light for fingerprint identification irradiated on the middle frame 10 and/or the second circuit board 2121 is reflected by the reflective layer 40 to avoid the detection light being blocked by the middle frame 10 or the second circuit board 2121, so that the detection light in the light-emitting area emit out of the protective cover plate 211, thereby improving the light utilization rate of the detection light source 31, and increasing the intensity of the detection light irradiated on the finger above the fingerprint identification area 214. Where, the second circuit board 2121 is connected to the liquid crystal panel 212 of the liquid crystal display screen 20.

Specifically, in the embodiment, as shown in FIG. 8, the reflective layer 40 may be respectively arranged on the border 11 at a position opposite to the light-emitting area and on a side of the second circuit board 2121 facing the detection light source 31, for reflecting the detection light irradiated on the second circuit board 2121. For example, as shown in FIG. 8, the reflective layer 40 may be arranged in the accommodation space 111 at a position opposite to the light-emitting area, and extend to the outside of the accommodation space 111 and cover the support part 112. In order to make detection light blocked by the second circuit board 2121 pass through the protective cover plate 211 and irradiate the finger above the fingerprint identification area 214, the blocked detection light needs to be reflected twice.

Specifically, in the embodiment, as shown in FIG. 8, the second circuit board 2121 is arranged on a same side of the liquid crystal panel 212 and the backlight module 22 of the liquid crystal display screen 20, and is arranged close to the detection light source 31; where, the second circuit board 2121 is located on the support board 12. In order to facilitate bending of the second circuit board 2121, the second circuit board 2121 may be a flexible circuit board. In the embodiment, the second circuit board 2121 may be bent and arranged on the same side of the liquid crystal panel 212 and the backlight module 22 of the liquid crystal display screen 20, and connected to the main board 50 of the mobile phone 100. Where, the connecting manner between the second circuit board 2121 and the main board 50 includes but is not limited to welding.

Further, in the embodiment, the reflective layer 40 may be a reflective film for reflecting the detection light in the prior art, or the reflective layer 40 may be a coating formed by spraying using a reflective material and used for reflecting the detection light. For example, the reflective material includes, but is not limited to, silver or aluminum. The reflective film may refer to a film material in the prior art which can have a relatively high reflectivity for the detection light used for fingerprint identification, where the relatively high reflectivity means that the reflectivity is greater than or equal to 90%. In the embodiment, its structure will not be further described in the embodiment.

It should be noted that, when the detection light sources 31 is entirely located in the accommodation space 111 of the frame 11, in order to avoid the detection light emitted by the detection light source 31 being blocked by the middle frame 10 or the second circuit board 2121, the light-emitting area of the detection light source 31 may be located at the side of the detection light source 31 close to the fingerprint identification area 214, and the middle frame 10 and the second circuit board 2121 may be provided with the reflective layer 40 at a position opposite to the light-emitting area of the detection light source 31, to change the light emitting angle of the detection light source 31, so that the detection light emitted by the detection light source 31 can emit out of the protective cover plate 211 and irradiate the finger above the fingerprint identification area 214 for fingerprint identification.

In the under-screen fingerprint identification apparatus provided by the present application, the detection light source is located below the edge area of the protective cover plate of the liquid crystal display screen, so that at least part of the detection light source is located in the accommodation space and is attached to the middle frame. Meanwhile, the arrangement of the reflective layer on the second circuit board of the liquid crystal display screen and the middle frame improves the light utilization rate of the detection light source. Therefore, the effect of under-screen fingerprint identification can be improved while reducing the increased width of the chin area of the mobile phone, which contributes to realization of the full screen of the electronic device.

In the description of the present application, it should be noted that unless otherwise specified and limited, terms "installation", "connecting", and "connection" should be understood generally, for example, it may be a fixed connection, an indirect connection through an intermediate medium, and internal communication of two elements or interaction between two elements. For those of ordinary skill in the art, specific meanings of the above terms in the present application may be understood according to specific situations.

In the description of the present application, it should be understood that orientation or position relationships indicated by terms "above", "below", "front", "rear", "vertical", "horizontal", "top", "bottom", "inside" and "outside" are orientation or position relationships based on the drawings. It is only for convenience of describing the present application and simplifying the description, instead of indicating or implying that the apparatus or component referred to must have a specific orientation or be constructed and operated in a specific orientation, thus it cannot be understood as a limitation to the present application. In the description of the present application, "a plurality of' means two or more, unless otherwise specified precisely and specifically.

Terms "first", "second", "third", "fourth", etc. (if any) in the specification and claims and the above drawings of the present application are used to distinguish similar objects, and are not necessarily used to describe a specific order or sequence. It should be understood that data used in this way may be interchanged under appropriate circumstances, so that the embodiments of the present application described herein can be implemented in an order other than those illustrated or described herein, for example. In addition, terms "including" and "having" and any variations thereof are intended to cover non-exclusive inclusion. For example, a process, a method, a system, a product or a device including a series of steps or units needs not be limited to those steps or units clearly listed, but may include other steps or units not clearly listed or inherent to the process, the method, the product or the device.

Finally, it should be noted that the above embodiments are only used to illustrate technical solutions of the present application, but not to limit it; although the present application has been described in detail with reference to the aforementioned embodiments, those of ordinary skill in the art should understand that the technical solutions described in the aforementioned embodiments can still be modified, or some or all of the technical features can be equivalently substituted; however, these modifications or substitutions do not make essence of corresponding technical solutions deviate from scope of the technical solutions of the embodiments of the present application.

## Claims

1. An under-screen fingerprint identification apparatus, applied to an electronic device with a liquid crystal display screen and a middle frame, wherein the under-screen fingerprint identification apparatus comprises a detection light source and a fingerprint identification module, the detection light source is located below an edge area of a protective cover plate of the liquid crystal display screen, the middle frame is used for supporting the liquid crystal display screen, and the middle frame is provided with an accommodation space at a position opposite to the detection light source, and the detection light source is at least partially located in the accommodation space and is attached to the middle frame; the fingerprint identification module is used for being arranged below the liquid crystal display screen, and a fingerprint identification area thereof is located in a display area of the liquid crystal display screen; wherein, the detection light source is used for emitting a detection light for fingerprint identification to a finger located above the fingerprint identification area of the liquid crystal display screen, and the fingerprint identification module is used for receiving a fingerprint detection light formed by irradiating the finger with the detection light and returning after passing through the liquid crystal display screen, to obtain fingerprint information of the finger.

2. The under-screen fingerprint identification apparatus according to claim 1, wherein the accommodation space is located on a border of the middle frame.

3. The under-screen fingerprint identification apparatus according to claim 2, wherein the border is an arc-shaped border with a thick middle and thin sides, and the accommodation space is provided close to a middle part of the border.

4. The under-screen fingerprint identification apparatus according to claim 3, wherein the liquid crystal display screen comprises a display module with the protective cover plate and a liquid crystal panel, the liquid crystal panel is located below the protective cover plate, and one side of the protective cover plate is provided with an extension part outside of the liquid crystal panel, and the detection light source is located below the extension part and arranged side by side with the liquid crystal panel; wherein, the extension part forms the edge area.

5. The under-screen fingerprint identification apparatus according to claim 4, wherein the border is provided with a support part for supporting the extension part, and the extension part is located on and attached to the support part.

6. The under-screen fingerprint identification apparatus according to claim 5, wherein the accommodation space is located below the support part and a gap is left between the detection light source and an inner wall of the accommodation space.

7. The under-screen fingerprint identification apparatus according to claim 2, wherein the accommodation space is a groove or a concave structure opened on the border for accommodating the detection light source.

8. The under-screen fingerprint identification apparatus according to claim 2, wherein the detection light source is attached to the border through a first circuit board, and the first circuit board is electrically connected to the detection light source and is used for controlling on or off of the detection light source.

9. The under-screen fingerprint identification apparatus according to claim 8, wherein the first circuit board is a flexible circuit board.

10. The under-screen fingerprint identification apparatus according to claim 9, wherein the first circuit board is attached to the border through a reinforcing plate, and the reinforcing plate is used for supporting the detection light source, wherein the first circuit board is located between the reinforcing plate and the detection light source.

11. The under-screen fingerprint identification apparatus according to claim 1, wherein a wavelength of the detection light is different from that of a backlight provided by a backlight module of the liquid crystal display screen and used for displaying an image, wherein the backlight module is located below the display module of the liquid crystal display screen.

12. The under-screen fingerprint identification apparatus according to claim 11, wherein the detection light emitted by the detection light source is infrared light, and the backlight provided by the backlight module is visible light.

13. The under-screen fingerprint identification apparatus according to any one of claims 1 to 12, wherein a light-emitting area of the detection light source is located at a side of the detection light source close to the fingerprint identification area, enabling the detection light in the light-emitting area to emit out of the middle frame for increasing an intensity of the detection light irradiated on the finger.

14. The under-screen fingerprint identification apparatus according to claim 13, wherein the detection light source comprises a light-emitting element for emitting the detection light, and the light-emitting element is located at the side of the detection light source close to the fingerprint identification area; and/or
the light-emitting element is obliquely arranged in the detection light source, so that the detection light in the light-emitting area can emit out of the middle frame for increasing the intensity of the detection light irradiated on the finger above the fingerprint identification area.

15. The under-screen fingerprint identification apparatus according to any one of claims 1 to 14, wherein the middle frame and a second circuit board of the liquid crystal display screen are provided with a reflective layer at a position opposite to a light-emitting area of the detection light source, wherein the second circuit board is connected to a liquid crystal panel of the liquid crystal display screen, and the reflective layer is used for causing the detection light in the light-emitting area to emit out of the protective cover plate, so as to increase an intensity of the detection light irradiated on the finger above the fingerprint identification area.

16. The under-screen fingerprint identification apparatus according to claim 15, wherein the reflective layer is respectively arranged in the accommodation space at a position opposite to the light-emitting area and on a side of the second circuit board facing the detection light source.

17. The under-screen fingerprint identification apparatus according to claim 15, wherein the second circuit board is arranged on a same side of the liquid crystal panel and a backlight module, and is arranged close to the detection light source.

18. The under-screen fingerprint identification apparatus according to claim 15 or 16, wherein the reflective layer is a reflective film for reflecting the detection light, or the reflective layer is a coating formed by spraying using a reflective material and used for reflecting the detection light.

19. The under-screen fingerprint identification apparatus according to claim 1, wherein the fingerprint identification module is arranged close to the detection light source, wherein the detection light source is located below the protective cover plate of a non-display area of the liquid crystal display screen, and the fingerprint identification module is located below a backlight module of a display area of the liquid crystal display screen.

20. The under-screen fingerprint identification apparatus according to claim 18, wherein the middle frame further comprises a support plate located in a middle part of the border, the border is arranged on a peripheral side of the support plate, and a first accommodation cavity and a second accommodation cavity vertically provided are formed between the border and the support plate, wherein part of the liquid crystal display screen is located in the first accommodation cavity, and a main board of the electronic device is located in the second accommodation cavity.

21. The under-screen fingerprint identification apparatus according to claim 18, wherein the fingerprint identification module is located below the liquid crystal display screen, wherein the support plate is provided with a first opening; the fingerprint identification module is arranged opposite to the first opening and is attached to the support plate or a bottom of the backlight module of the liquid crystal display screen, and the first opening is used for transmitting the fingerprint detection light passing through the liquid crystal display screen to the fingerprint identification module.

22. The under-screen fingerprint identification apparatus according to claim 20, wherein the liquid crystal display screen is provided with a light-transmitting area for transmitting the fingerprint detection light to the fingerprint identification module through a backlight module.

23. The under-screen fingerprint identification apparatus according to claim 21, wherein the liquid crystal display screen comprises the backlight module, the backlight module comprises an optical module capable of transmitting the fingerprint detection light and a steel plate, the fingerprint identification module is located below the steel plate, and the steel plate is provided with a second opening at a position opposite to the fingerprint identification module, wherein the second opening is used for transmitting the fingerprint detection light transmitted through the optical module to the fingerprint identification module, and the second opening is the light-transmitting area.

24. An electronic device, comprising a middle frame, a liquid crystal display screen provided in the middle frame, and the under-screen fingerprint identification apparatus according to any one of claims 1 to 23.
